# FASCICULE DE BREVET EUROPEEN

(11) **EP 3 666 974 B1**
(45) Date de publication et mention de la délivrance du brevet: **27.07.2022**
(21) Numéro de dépôt: 19214273.5
(22) Date de dépôt: 06.12.2019
(51) Int. Cl.: E01C 5/00, E01C 9/00, E01C 11/00, E01C 17/00, H01L 31/048, H02S 20/10, H02S 20/21, H02S 40/36, F24S 20/64, E01F 9/553, G08G 1/00, G08G 1/14, E04H 6/42, F21S 8/02

(54) **DALLE DE RECOUVREMENT INTELLIGENTE DESTINÉE À UN SYSTÈME DE PAVEMENT POUR CHAUSSÉE**
INTELLIGENTE ABDECKPLATTE FÜR STRASSENBELAGSYSTEM
SMART COVERING SLAB INTENDED FOR A PAVEMENT SYSTEM FOR A ROAD

(30) Priorité: 10.12.2018 FR 1872584
(43) Date de publication de la demande: 17.06.2020
(73) Titulaire: Lyon Parc Auto - LPA - Societe pour la Realisation et la Gestion d'Equipements, 69002 Lyon (FR)
(72) Inventeur: BOSSIN, Philippe, 69380 Lissieu (FR); FAVRE, Bernard, 69008 Lyon (FR)
(74) Mandataire: Germain Maureau

(56) Documents cités:
- WO-A1-2018/158598
- WO-A2-2006/113169
- US-A1- 2009 116 241
- US-A1- 2011 302 858
- US-A1- 2016 301 355

## Description

### Domaine de l'invention

La présente invention se rapporte à une dalle de recouvrement destinée à un système de pavement pour chaussée.

### Art antérieur

De manière connue, le document US 2016/0301355 A1 décrit un pavé comprenant une surface supérieure, une surface inférieure opposée et une épaisseur séparant la face supérieure de la face inférieure. Le pavé définit ainsi une cavité imperméable. Le pavé comprend un système de fixation permettant de se lier à un pavé adjacent. Ledit système de fixation est également utilisé pour connecter électriquement le pavé à un pavé adjacent.

D'autres exemples d'art antérieur peuvent être trouvés dans les documents WO2018158598A1 et US2009116241A1.

Toutefois, ces solutions ne donnent pas une entière satisfaction.

En effet, un pavé définissant une cavité imperméable est compliqué à mettre en œuvre.

De plus, le système de fixation ne permet au pavé que de se connecter électriquement aux pavés adjacents.

La présente invention permet de résoudre tout ou partie des inconvénients mentionnés ci-dessus.

### Exposé de l'invention

A cet effet, la présente invention concerne une dalle de recouvrement destinée à un système de pavement pour chaussée, la dalle de recouvrement comprenant :
- un châssis de soutènement configuré pour être positionné sur la chaussée et comprenant une pluralité d'orifices de passage, lesdits orifices de passage étant adaptés pour permettre le passage d'éléments d'alimentation en énergie et/ou d'éléments de communication; et
- un élément de recouvrement adapté pour recouvrir le châssis de soutènement et comprenant :
   o une face de circulation, ladite face de circulation comprenant :
   o une unité de communication ;
   o une unité de contrôle ; et
   o l'unité de contrôle et/ou l'unité de communication comprend au moins une borne d'entrée/sortie destinée à être raccordée à un élément d'alimentation en énergie ou à un élément de communication traversant un orifice de passage, et au moins un orifice de passage étant situé à proximité immédiate d'un coin dudit châssis de soutènement.

Selon un avantage, une unité de communication permet à l'unité de contrôle d'envoyer ou de recevoir des données.

Avantageusement, la face de circulation de l'élément de recouvrement est configurée pour former une surface de circulation lorsque la dalle de recouvrement est assemblée à au moins une autre dalle de recouvrement.

Selon un avantage, une surface de circulation est une surface sur laquelle un véhicule peut circuler.

Selon un mode de réalisation, la dalle de recouvrement s'étend sensiblement horizontalement.

Au sens de la présente invention, sensiblement horizontalement signifie horizontalement ou horizontalement à 5% près.

Selon un mode de réalisation, l'élément de recouvrement est plan. Selon un avantage, un élément de recouvrement plan permet de créer une face de circulation plus agréable pour des usagers de ladite face de circulation.

Selon un mode de réalisation, l'élément de recouvrement comprend deux éléments maintien s'étendant selon un axe commun. Le châssis de soutènement comprend deux orifices de maintien adaptés pour recevoir chacun un élément de maintien. Un telle configuration permet d'obtenir un élément de recouvrement fixé de manière amovible au châssis de soutènement.

Selon un avantage, une dalle de recouvrement comprenant une pluralité d'orifices de passage adaptés pour permettre le passage d'éléments d'alimentation en énergie et/ou d'éléments de communication permet de faciliter le passage d'éléments d'alimentation en énergie ou d'éléments de communication.

Au sens de la présente invention, « à proximité immédiate des coins du châssis de soutènement » signifie « sur les coins du châssis de soutènement » ou « sur les coins du châssis de soutènement à 5% de la longueur du châssis de soutènement près ».

Selon un avantage, des orifices de passage situés à proximité immédiate des coins du châssis de soutènement permettent de faciliter le passage d'au moins un élément d'alimentation en énergie et/ou d'au moins un élément de communication de la dalle de recouvrement à d'autres dalles de recouvrement.

Selon un mode de réalisation, l'élément de recouvrement comprend une unité photovoltaïque.

Selon un mode de réalisation, l'unité photovoltaïque comprend une pluralité de panneaux photovoltaïques.

Avantageusement, une telle configuration permet à la dalle de recouvrement d'avoir une alimentation en énergie électrique.

Selon un mode de réalisation, l'élément de recouvrement comprend un boîtier d'intégration comprenant au moins un orifice de connexion adapté pour permettre le passage d'éléments d'alimentation en énergie ou d'éléments de communication.

Selon un avantage, un boîtier d'intégration comprenant au moins un d'orifice de connexion adapté pour permettre le passage d'éléments d'alimentation en énergie ou d'éléments de communication permet de faciliter le passage d'éléments d'alimentation en énergie et/ou d'éléments de communication.

Selon un mode de réalisation, le boîtier d'intégration est fixé à la face de l'élément de recouvrement disposée en regard de la chaussée.

Une telle configuration permet d'intégrer plus facilement au moins un équipement à la dalle de recouvrement.

Selon un mode de réalisation, le boîtier d'intégration comprend une unité de stockage d'énergie électrique.

Selon un avantage, une unité de stockage d'énergie électrique permet à la dalle de recouvrement de disposer d'une source d'énergie électrique.

Selon un mode de réalisation, le boîtier d'intégration comprend une unité de transfert d'énergie électrique.

Selon un mode de réalisation, l'unité de transfert d'énergie électrique est adaptée pour recevoir de l'énergie électrique.

Selon un mode de réalisation, l'unité de transfert d'énergie électrique est adaptée pour envoyer de l'énergie électrique.

Une telle configuration permet à la dalle de recouvrement d'être alimentée en énergie électrique ou à l'inverse d'alimenter un appareil extérieur.

Selon un mode de réalisation, le boîtier d'intégration comprend au moins un des capteurs suivants :
- capteur de luminosité ;
- capteur acoustique ;
- capteur de qualité de l'air ;
- capteur thermique
- capteur d'identification ;
- capteur de localisation ;
- capteur de proximité ; et
- capteur de charge ;
- capteur d'électricité.

Selon un avantage, un capteur d'identification est un capteur tel qu'un lecteur NFC ou un lecteur RFID par exemple.

Selon un avantage, un capteur de localisation est un capteur tel qu'un GPS par exemple.

Selon un avantage, un capteur de proximité est un capteur tel qu'un capteur infrarouge ou à ultrasons par exemple.

Une telle configuration, et plus particulièrement un boîtier d'intégration comprenant un capteur de luminosité permet d'estimer avec une bonne précision la luminosité reçue par la dalle de recouvrement.

Une telle configuration, et plus particulièrement un boîtier d'intégration comprenant un capteur acoustique permet d'estimer avec une bonne précision le niveau sonore à proximité de la dalle de recouvrement.

Une telle configuration, et plus particulièrement un boîtier d'intégration comprenant un capteur de qualité de l'air permet d'estimer avec une bonne précision le niveau de qualité de l'air à proximité de la dalle de recouvrement.

Une telle configuration, et plus particulièrement un boîtier d'intégration comprenant un capteur thermique permet d'estimer avec une bonne précision le la température à proximité de la dalle de recouvrement.

Une telle configuration, et plus particulièrement un boîtier d'intégration comprenant un capteur d'identification permet d'identifier la dalle de recouvrement.

Une telle configuration, et plus particulièrement un capteur de localisation permet d'estimer avec une bonne précision la localisation de la dalle de recouvrement.

Une telle configuration, et plus particulièrement un boîtier d'intégration comprenant un capteur de proximité permet d'estimer avec une bonne précision la distance entre un élément extérieur à la dalle de recouvrement et ladite dalle de recouvrement.

Une telle configuration, et plus particulièrement un boîtier d'intégration comprenant un capteur de charge permet d'estimer avec une bonne précision la charge exercée sur la dalle de recouvrement.

Selon un mode de réalisation, le boîtier d'intégration comprend une unité d'émission acoustique.

Une telle configuration permet à la dalle de recouvrement d'émettre des sons et permet ainsi de communiquer avec des usagers de la surface de circulation.

Selon un mode de réalisation, l'unité acoustique est un haut-parleur.

Selon un mode de réalisation, l'unité d'émission acoustique est commandée par l'unité de commande.

Selon un mode de réalisation, la face de circulation comprend une unité d'émission de lumière.

Une telle configuration permet à la dalle de recouvrement d'émettre de la lumière et permet ainsi de communiquer avec des usagers de la surface de circulation ou ceux situés à proximité de celle-ci.

Selon un mode de réalisation, l'unité d'émission de lumière comprend des LEDs.

Selon un mode de réalisation, l'unité d'émission de lumière est commandée par l'unité de commande. Une telle configuration permet à l'unité de commande de commander à l'unité d'émission de lumière d'émettre de la lumière lorsque le niveau de lumière reçue par la dalle est sous un seuil prédéterminé par exemple.

Selon un mode de réalisation, la face de circulation comprend un actionneur mécatronique.

Une telle configuration permet à l'unité de commande d'exercer une action mécanique pilotée sur la dalle de recouvrement. Une telle configuration permet notamment de favoriser les opérations de maintenance ou la gestion du bon usage de la dalle.

Selon un mode de réalisation, la face de circulation comprend une unité de recouvrement.

Une telle configuration permet d'assurer une bonne protection à l'unité photovoltaïque ainsi qu'aux éventuels autres éléments de la face de circulation tels que l'unité d'émission de lumière par exemple.

Selon un mode de réalisation, l'unité de recouvrement est en verre trempé.

Une telle configuration permet de laisser passer les rayons du soleil, garantissant ainsi un bon fonctionnement des unités photovoltaïques.

Une telle configuration permet de laisser passer la lumière émise par l'unité d'émission de lumière.

L'invention concerne également un système de pavement pour chaussée configuré pour former une surface de circulation sensiblement plane, ledit système de pavement comprenant :
- une pluralité de dalles de recouvrement distinctes les unes des autres et assemblées entre elles, lesdites dalles de recouvrement comprenant chacune :
   o un châssis de soutènement configuré pour être positionné sur la chaussée ;
   o un élément de recouvrement adapté pour recouvrir le châssis de soutènement et comprenant :
      ▪ une face de circulation, les faces de circulation des éléments de recouvrement étant configurées pour former la surface de circulation lorsque les dalles de recouvrement sont assemblées entre elles ;
      ▪ une unité de communication ; et
      ▪ une unité de contrôle.

Au sens de la présente invention, sensiblement plane signifie plane ou plane à 5° près.

Selon un avantage, un système de pavement pour chaussée configuré pour former une surface de circulation comprenant une pluralité de dalles de recouvrement permet de faciliter la manutention et la mise en œuvre d'un tel système de pavement.

Selon un avantage, un châssis de soutènement adapté pour soutenir au moins une partie du poids d'un véhicule permet au système de pavement de supporter la circulation de véhicules routiers.

Selon un mode de réalisation, le châssis de soutènement est adapté pour soutenir un poids entre 2,5 tonnes et 3,5 tonnes. Avantageusement, une telle configuration permet à un châssis de soutènement de supporter la force appliquée par une roue d'un véhicule routier pesant un total de 19 tonnes et ayant 2 essieux pour un total de 6 roues.

Selon un mode de réalisation, l'unité de contrôle de chacune des dalles de recouvrement est configurable indépendamment des unités de contrôle des autres dalles de recouvrement.

Une telle configuration permet d'activer certaines fonctionnalités sur certaines dalles de recouvrement sans activer ces fonctionnalités sur d'autres dalles de recouvrement. Cela permet de limiter la consommation d'énergie du système de pavement.

Les différents aspects définis ci-dessus non incompatibles peuvent être combinés.

### Brève description des figures

L'invention sera encore mieux comprise à l'aide de la description détaillée qui est exposée ci-dessous en regard des dessins annexés dans lesquels :
[Fig. 1] représente une dalle de recouvrement conformément à la présente invention ;
[Fig. 2] représente un orifice de passage conformément à la présente invention ;
[Fig. 3] représente un système de pavement conformément à la présente invention ;
[Fig. 4] représente une vue schématique d'un système de pavement conformément à la présente invention ; et
[Fig. 5] représente une vue schématique d'un système de pavement conformément à la présente invention.

### Description en référence aux figures

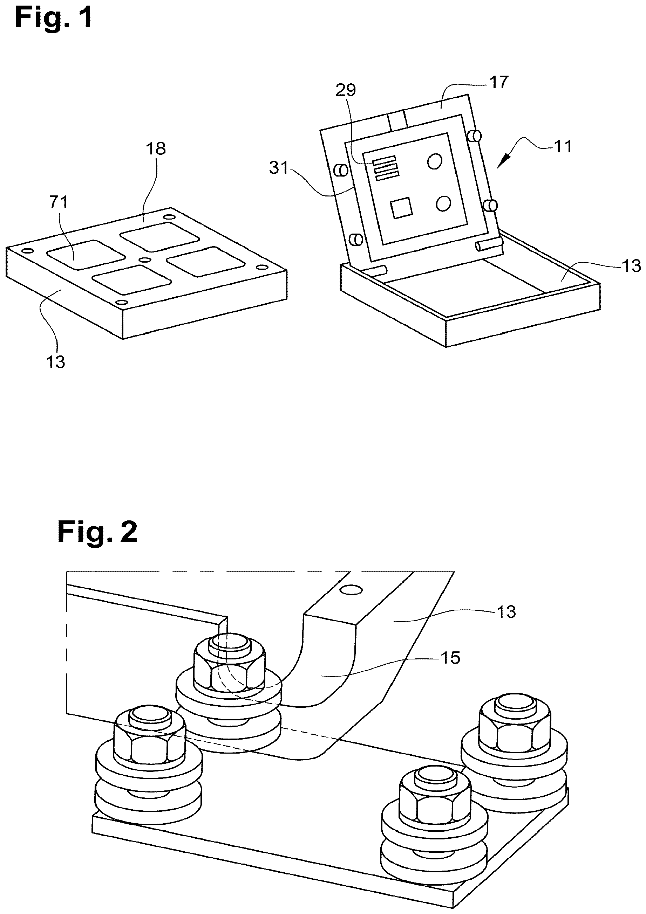

La [Fig. 1] décrit, une dalle de recouvrement 11 s'étendant sensiblement horizontalement destinée à un système de pavement pour chaussée 101.

Au sens de la présente invention, sensiblement horizontalement signifie horizontalement ou horizontalement à 5% près.

La dalle de recouvrement 11 comprend un châssis de soutènement 13 configuré pour être positionné sur la chaussée 101.

Ledit châssis de soutènement 13 comprend une pluralité d'orifices de passage 15 situés à proximité immédiate de ses coins comme illustré dans la [Fig. 2].

Au sens de la présente invention, « à proximité immédiate des coins du châssis de soutènement » signifie « sur les coins du châssis de soutènement » ou « sur les coins du châssis de soutènement à 5% de la longueur du châssis de soutènement près ».

Les orifices de passage 15 sont adaptés pour permettre le passages d'éléments d'alimentation en énergie et/ou d'éléments de communication

Selon un avantage, une dalle de recouvrement 11 comprenant une pluralité d'orifices de passage 15 adaptés pour permettre le passage d'éléments d'alimentation en énergie et/ou d'éléments de communication permet de faciliter le passage d'éléments d'alimentation en énergie et/ou d'éléments de communication.

Selon un avantage, des orifices de passage 15 situés à proximité immédiate des coins du châssis de soutènement 13 permet de faciliter le passage d'au moins un élément d'alimentation en énergie et/ou au moins un élément de communication de la dalle de recouvrement 11 à d'autres dalles de recouvrement 11.

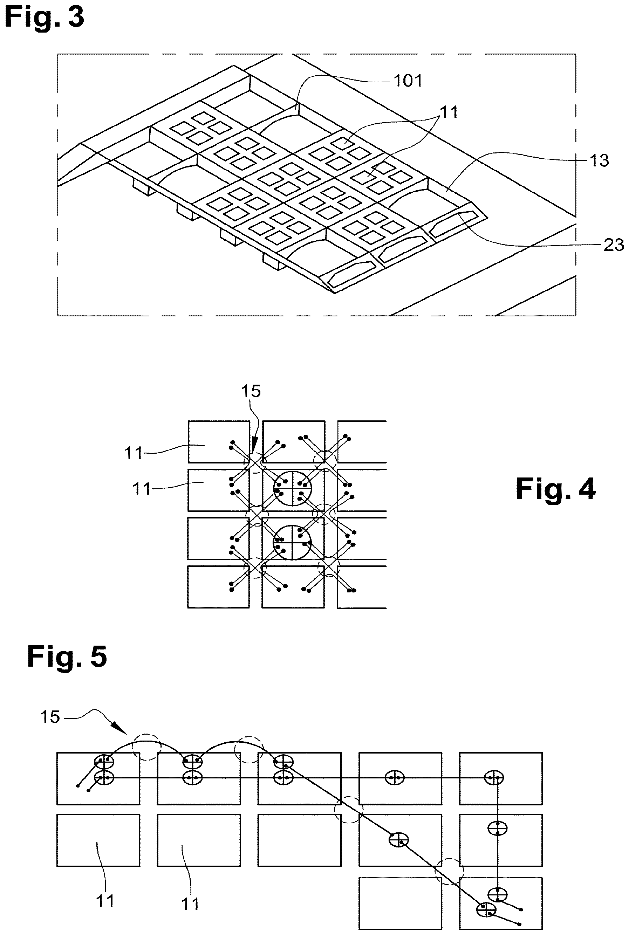

Avantageusement, une telle configuration permet à une dalle de recouvrement 11 d'être connectée avec huit dalles de recouvrement 11 adjacentes, comme illustré sur les [Fig. 4] et [Fig. 5]. Une telle configuration permet de faciliter la liaison d'une dalle de recouvrement 11 avec une autre dalle de recouvrement 11 qui ne lui est pas adjacente.

La [Fig. 5] décrit deux exemples de liaison d'une dalle de recouvrement 11 à une autre dalle de recouvrement 11. Le premier exemple de liaison correspond à l'art antérieur et permet de relier une dalle de recouvrement 11 à une autre dalle de recouvrement 11 en passant par 5 dalles de recouvrement 11 intermédiaires. Le deuxième exemple de liaison selon l'invention permet de relier une dalle de recouvrement 11 à une autre dalle de recouvrement 11 en passant par seulement 3 dalles de recouvrement 11 intermédiaires, ce qui représente une simplification importante.

La dalle de recouvrement 11 comprend un élément de recouvrement 17 adapté pour recouvrir le châssis de soutènement 13.

Ledit élément de recouvrement 17 comprend une face de circulation 18.

La face de circulation 18 de l'élément de recouvrement 17 étant configurée pour former une surface de circulation lorsque la dalle de recouvrement 11 est assemblée à au moins une autre dalle de recouvrement 11.

Selon un avantage, une surface de circulation 18 est une surface sur laquelle un véhicule peut circuler.

Selon un mode de réalisation, l'élément de recouvrement 17 est plan. Selon un avantage, un élément de recouvrement 17 plan permet de créer une face de circulation 18 plus agréable pour des usagers de ladite face de circulation 18.

Selon un mode de réalisation, l'élément de recouvrement 17 comprend deux éléments maintien s'étendant selon un axe commun. Le châssis de soutènement 13 comprend deux orifices de maintien adaptés pour recevoir chacun un élément de maintien. Un telle configuration permet d'obtenir un élément de recouvrement 17 fixé de manière amovible au châssis de soutènement 13.

Selon un mode de réalisation, la face de circulation 18 comprend une unité de communication.

La face de circulation 18 comprend également une unité de contrôle.

Selon un avantage, une unité de communication permet à l'unité de contrôle d'envoyer ou de recevoir des données.

L'unité de contrôle et/ou l'unité de communication comprend au moins une borne d'entrée/sortie destinée à être raccordée à un élément d'alimentation en énergie ou à un élément de communication traversant un orifice de passage 15.

Selon un mode de réalisation, face de circulation 18 comprend une unité d'émission de lumière.

Une telle configuration permet à la dalle de recouvrement 11 d'émettre de la lumière et permet ainsi de communiquer avec des usagers de la surface de circulation.

Selon un mode de réalisation, l'unité d'émission de lumière comprend des LEDs.

Selon un mode de réalisation, l'unité d'émission de lumière est commandée par l'unité de commande. Une telle configuration permet à l'unité de commande de commander à l'unité d'émission de lumière d'émettre de la lumière lorsque le niveau de lumière reçue par la dalle est sous un seuil prédéterminé par exemple.

L'élément de recouvrement 17 comprend une unité photovoltaïque 71.

Selon un mode de réalisation, l'unité photovoltaïque 71 comprend une pluralité de panneaux photovoltaïques.

Avantageusement, une telle configuration permet à la dalle de recouvrement 11 d'avoir une alimentation en énergie électrique.

L'élément de recouvrement 17 comprend un boîtier d'intégration 29 fixé à la face de l'élément de recouvrement 17 disposée en regard de la chaussée 101.

Selon un mode de réalisation, le boîtier d'intégration 29 comprend au moins un orifice de connexion 31 adapté pour permettre le passage d'éléments d'alimentation en énergie et/ou d'éléments de communication.

Selon un avantage, un élément de recouvrement 17 comprenant un boîtier d'intégration 29 permet d'intégrer plus facilement au moins un équipement à la dalle de recouvrement.

Selon un avantage, un boîtier d'intégration 29 comprenant au moins un orifice de connexion 31 adapté pour permettre le passage d'éléments d'alimentation en énergie et/ou d'éléments de communication permet de faciliter le passage d'éléments d'alimentation en énergie et/ou d'éléments de communication.

Selon un mode de réalisation, le boîtier d'intégration 29 comprend une unité de stockage d'énergie électrique.

Selon un avantage, une unité de stockage d'énergie électrique permet à la dalle de recouvrement de disposer une source d'énergie électrique lorsque l'unité photovoltaïque ne produit pas d'énergie électrique.

Selon un mode de réalisation, le boîtier d'intégration 29 comprend une unité de transfert d'énergie électrique.

Avantageusement, l'unité de transfert d'énergie permet à la dalle de recouvrement 11 de recevoir de l'énergie électrique pour alimenter l'unité de contrôle ou charger la batterie par exemple.

Avantageusement, l'énergie électrique reçue par l'unité de transfert d'énergie est fournie par un usager de la salle de recouvrement 11.

Selon un avantage, l'unité de transfert d'énergie permet à la dalle de recouvrement 11 d'envoyer de l'énergie électrique pour alimenter un usager de la dalle de recouvrement par exemple.

Selon un mode de réalisation, le boitier d'intégration 29 comprend au moins un des capteurs suivants :
- capteur de luminosité ;
- capteur acoustique ;
- capteur de qualité de l'air ;
- capteur thermique ;
- capteur d'identification tel qu'un lecteur NFC ou un lecteur RFID par exemple ;
- capteur de localisation tel qu'un GPS par exemple ;
- capteur de proximité tel qu'un capteur infrarouge par exemple ; et
- capteur de charge.

Une telle configuration, et plus particulièrement un boîtier d'intégration 29 comprenant un capteur de luminosité permet d'estimer avec une bonne précision la luminosité reçue par la dalle de recouvrement 11.

Une telle configuration, et plus particulièrement un boîtier d'intégration 29 comprenant un capteur acoustique permet d'estimer avec une bonne précision le niveau sonore à proximité de la dalle de recouvrement 11.

Une telle configuration, et plus particulièrement un boîtier d'intégration 29 comprenant un capteur de qualité de l'air permet d'estimer avec une bonne précision le niveau de qualité de l'air à proximité de la dalle de recouvrement 11.

Une telle configuration, et plus particulièrement un boîtier d'intégration 29 comprenant un capteur thermique permet d'estimer avec une bonne précision la température à proximité de la dalle de recouvrement 11.

Une telle configuration, et plus particulièrement un boîtier d'intégration comprenant un capteur d'identification permet d'identifier la dalle de recouvrement.

Une telle configuration, et plus particulièrement un capteur de localisation permet d'estimer avec une bonne précision la localisation de la dalle de recouvrement.

Une telle configuration, et plus particulièrement un boîtier d'intégration 29 comprenant un capteur de proximité permet d'estimer avec une bonne précision la distance entre un élément extérieur à la dalle de recouvrement et ladite dalle de recouvrement.

Une telle configuration, et plus particulièrement un boîtier d'intégration 29 comprenant un capteur de charge permet d'estimer avec une bonne précision la charge exercée sur la dalle de recouvrement.

Une telle configuration, et plus particulièrement un boîtier d'intégration 29 comprenant un capteur d'électricité, permet d'acquérir de l'énergie électrique fournie par un élément extérieur à la dalle de recouvrement et transmise à la dalle de recouvrement.

Selon un mode de réalisation, la transmission se fait par conduction.

Selon un autre mode de réalisation, la transmission se fait par induction.

Selon un mode de réalisation, le boîtier d'intégration 29 comprend au moins un des actionneurs suivants :
- unité d'émission acoustique ;
- unité d'émission vibratoire ;
- actionneur mécatronique ; ou
- unité de transmission électrique.

Selon un mode de réalisation, le boîtier d'intégration 29 comprend une unité d'émission acoustique.

Une telle configuration permet à la dalle de recouvrement 11 d'émettre des sons et permet ainsi de communiquer avec des usagers de la surface de circulation.

Selon un mode de réalisation, l'unité acoustique est un haut-parleur.

Selon un mode de réalisation, l'unité d'émission acoustique est commandée par l'unité de commande.

Selon un mode de réalisation, le boîtier d'intégration 29 comprend une unité d'émission vibratoire. Une telle configuration permet à la dalle de recouvrement 11 d'émettre des vibrations et permet ainsi de transmettre des informations aux usagers de la face de circulation 18.

Selon un mode de réalisation, le boîtier d'intégration 29 comprend un actionneur mécatronique permettant d'exercer une action mécanique pilotée sur la dalle de recouvrement. Une telle configuration permet de favoriser les opérations de maintenance ou la gestion du bon usage de la dalle.

Selon un mode de réalisation, le boîtier d'intégration 29 comprend une unité de transmission électrique, permettant à la dalle de recouvrement de transmettre de l'énergie électrique à un élément extérieur à la dalle de recouvrement et captée par l'élément extérieur.

Selon un mode de réalisation, la transmission se fait par conduction.

Selon un autre mode de réalisation, la transmission se fait par induction.

Selon un mode de réalisation, la face de circulation 18 comprend une unité de recouvrement.

Une telle configuration permet d'assurer une bonne protection à l'unité photovoltaïque 71 ainsi qu'aux éventuels autres éléments de la face de circulation tels que l'unité d'émission de lumière par exemple.

Selon un mode de réalisation, l'unité de recouvrement est en verre trempé.

Une telle configuration permet de laisser passer les rayons du soleil, garantissant ainsi un bon fonctionnement des unités photovoltaïques.

Une telle configuration permet de laisser passer la lumière émise par l'unité d'émission de lumière.

Comme illustré dans la [Fig. 3], l'invention concerne également un système de pavement pour chaussée 101 configuré pour former une surface de circulation sensiblement plane.

Ledit système de pavement comprend une pluralité de dalles de recouvrement 11 distinctes les unes des autres et assemblées entre elles.

Lesdites dalles de recouvrement 11 comprenant chacune :
- un châssis de soutènement 13 configuré pour être positionné sur la chaussée 101 ;
- un élément de recouvrement 17 adapté pour recouvrir le châssis de soutènement 13 et comprenant :
- une face de circulation 18, ladite face de circulation 18 comprenant au moins une unité photovoltaïque, les faces de circulation des éléments de recouvrement étant configurées pour former la surface de circulation lorsque les dalles de recouvrement 11 sont assemblées entre elles ;
- une unité de communication ; et
- une unité de contrôle.

Au sens de la présente invention, sensiblement plane signifie plane ou plane à 5° près.

Selon un avantage, un système de pavement pour chaussée 101 configuré pour former une surface de circulation comprenant une pluralité de dalles de recouvrement 11 permet de faciliter la manutention et la mise en œuvre d'un tel système de pavement .

Selon un avantage, un châssis de soutènement 13 adapté pour soutenir au moins une partie du poids d'un véhicule permet au système de pavement de supporter la circulation de véhicules routiers.

Selon un mode de réalisation, le châssis de soutènement 13 est adapté pour soutenir un poids entre 2,5 tonnes et 3,5 tonnes. Avantageusement, une telle configuration permet à un châssis de soutènement 13 de supporter la force appliquée par une roue d'un véhicule routier pesant un total de 19 tonnes et ayant 2 essieux pour un total de 6 roues.

Selon un mode de réalisation, l'unité de contrôle de chacune des dalles de recouvrement 11 est configurable indépendamment des unités de contrôle des autres dalles de recouvrement 11.

Une telle configuration permet d'activer certaines fonctionnalités sur certaines dalles de recouvrement 11 sans activer ces fonctionnalités sur d'autres dalles de recouvrement 11. Cela permet de limiter la consommation d'énergie du système de pavement .

Bien entendu, l'invention n'est pas limitée aux modes de réalisation représentés et décrits ci-avant, mais en couvre au contraire toutes les variantes.

## Revendications

1. Dalle de recouvrement (11) destinée à un système de pavement pour chaussée (101), la dalle de recouvrement (11) comprenant :
un châssis de soutènement (13) configuré pour être positionné sur la chaussée (101) et comprenant une pluralité d'orifices de passage (15), lesdits orifices de passage (15) étant adaptés pour permettre le passage d'éléments d'alimentation en énergie et/ou d'éléments de communication; et
un élément de recouvrement (17) adapté pour recouvrir le châssis de soutènement (13) et comprenant :
une face de circulation (18), ladite face de circulation (18) comprenant :
une unité de communication ;
une unité de contrôle ; et
l'unité de contrôle et/ou l'unité de communication comprend au moins une borne d'entrée/sortie destinée à être raccordée à un élément d'alimentation en énergie ou à un élément de communication traversant un orifice de passage (15), **caractérisé en ce que** l'au moins un orifice de passage (15) est situé à proximité immédiate d'un coin dudit châssis de soutènement (13).

2. Dalle de recouvrement (11) selon la revendication 1, dans laquelle l'élément de recouvrement comprend une unité photovoltaïque (71).

3. Dalle de recouvrement (11) selon l'une quelconque des revendications 1 ou 2, dans laquelle l'élément de recouvrement (17) comprend un boîtier d'intégration (29) comprenant au moins un orifice de connexion (31) adapté pour permettre le passage d'éléments d'alimentation en énergie ou d'éléments de communication.

4. Dalle de recouvrement (11) selon la revendication 3, dans laquelle le boîtier d'intégration (29) est fixé à la face de l'élément de recouvrement (17) disposée en regard de la chaussée (101).

5. Dalle de recouvrement (11) selon l'une quelconque des revendications 3 ou 4, dans laquelle le boîtier d'intégration (29) comprend une unité de stockage d'énergie électrique.

6. Dalle de recouvrement (11) selon la revendication 5, dans laquelle le boîtier d'intégration (29) comprend une unité de transfert d'énergie électrique.

7. Dalle de recouvrement (11) selon l'une quelconque des revendications 3 à 6, dans laquelle le boîtier d'intégration (29) comprend au moins un des capteurs suivants :
capteur de luminosité ;
capteur acoustique ;
capteur de qualité de l'air ;
capteur thermique ;
capteur d'identification ;
capteur de localisation ;
capteur de proximité ;
capteur de charge ; et
capteur d'électricité.

8. Dalle de recouvrement (11) selon l'une quelconque des revendications 3 à 7, dans laquelle le boîtier d'intégration (29) comprend une unité d'émission acoustique.

9. Dalle de recouvrement (11) selon l'une quelconque des revendications 1 à 8, dans laquelle la face de circulation (18) comprend une unité d'émission de lumière.

10. Dalle de recouvrement (11) selon l'une quelconque des revendications 1 à 9, dans laquelle la face de circulation (18) comprend un actionneur mécatronique.

11. Dalle de recouvrement (11) selon l'une quelconque des revendications 1 à 10, dans laquelle la face de circulation (18) comprend une unité de transmission électrique.

12. Dalle de recouvrement (11) selon l'une quelconque des revendications 1 à 11, dans laquelle la face de circulation (18) comprend une unité de recouvrement.

13. Dalle de recouvrement (11) selon la revendication 12, dans laquelle l'unité de recouvrement est en verre trempé.

14. Système de pavement pour chaussée (101) configuré pour former une surface de circulation sensiblement plane, ledit système de pavement comprenant :
une pluralité de dalles de recouvrement (11) distinctes les unes des autres et
assemblées entre elles, lesdites dalles de recouvrement (11) selon l'une quelconque des revendications 1 à 13 comprenant chacune :
un châssis de soutènement (13) configuré pour être positionné sur la chaussée (101) ; un élément de recouvrement (17) adapté pour recouvrir le châssis de soutènement (13) et comprenant :
une face de circulation (18), les faces de circulation des éléments de recouvrement étant configurées pour former la surface de circulation lorsque les dalles de recouvrement (11) sont assemblées entre elles ;
une unité de communication ; et
une unité de contrôle.

15. Système de pavement pour chaussée (101) selon la revendication 14, dans lequel l'unité de contrôle de chacune des dalles de recouvrement (11) est configurable indépendamment des unités de contrôle des autres dalles de recouvrement (11).

## Patentansprüche

1. Abdeckplatte (11) für ein Belagsystem für eine Straße (101), wobei die Abdeckplatte (11) umfasst:
ein Stützgestell (13), das dazu konfiguriert ist, um auf der Straße (101) positioniert zu werden, und das eine Vielzahl von Durchgangsöffnungen (15) umfasst, wobei die Durchgangsöffnungen (15) angepasst sind, um das Passieren von Energieversorgungselementen und/oder Kommunikationselementen zu ermöglichen; und
ein Abdeckelement (17), das dazu angepasst ist, um das Stützgestell (13) abzudecken, und das umfasst:
eine Zirkulationsfläche (18), wobei die Zirkulationsfläche (18) umfasst:
eine Kommunikationseinheit;
eine Steuereinheit; und
wobei die Steuereinheit und/oder die Kommunikationseinheit mindestens eine Eingangs-/Ausgangsklemme umfasst, die dazu bestimmt ist, mit einem Energieversorgungselement oder einem Kommunikationselement verbunden zu werden, das eine Durchgangsöffnung (15) durchquert, **dadurch gekennzeichnet, dass** sich das mindestens eine Durchgangsöffnung (15) in unmittelbarer Nähe einer Ecke des Stützgestells (13) befindet.

2. Abdeckplatte (11) nach Anspruch 1, wobei das Abdeckelement eine Photovoltaikeinheit (71) umfasst.

3. Abdeckplatte (11) nach einem der Ansprüche 1 oder 2, wobei das Abdeckelement (17) ein Integrationsgehäuse (29) umfasst, das mindestens eine Verbindungsöffnung (31), die angepasst ist, um das Passieren von Energieversorgungselementen oder Kommunikationselementen zu ermöglichen.

4. Abdeckplatte (11) nach Anspruch 3, wobei das Integrationsgehäuse (29) an der Fläche des Abdeckelements (17) befestigt ist, die zur Straße (101) zeigend angeordnet ist.

5. Abdeckplatte (11) nach einem der Ansprüche 3 oder 4, wobei das Integrationsgehäuse (29) eine Speichereinheit für elektrische Energie umfasst.

6. Abdeckplatte (11) nach Anspruch 5, wobei das Integrationsgehäuse (29) eine Transfereinheit für elektrische Energie umfasst.

7. Abdeckplatte (11) nach einem der Ansprüche 3 bis 6, wobei das Integrationsgehäuse (29) mindestens einen der folgenden Sensoren umfasst:
Helligkeitssensor;
Akustiksensor;
Luftqualitätssensor;
thermischer Sensor;
Identifikationssensor;
Lokalisierungssensor;
Nähesensor;
Ladungssensor; und
Stromsensor.

8. Abdeckplatte (11) nach einem der Ansprüche 3 bis 7, wobei das Integrationsgehäuse (29) eine Akustikemissionseinheit umfasst.

9. Abdeckplatte (11) nach einem der Ansprüche 1 bis 8, wobei die Zirkulationsfläche (18) eine Lichtemissionseinheit umfasst.

10. Abdeckplatte (11) nach einem der Ansprüche 1 bis 9, wobei die Zirkulationsfläche (18) einen mechatronisches Stellglied umfasst.

11. Abdeckplatte (11) nach einem der Ansprüche 1 bis 10, wobei die Zirkulationsfläche (18) eine Stromübertragungseinheit umfasst.

12. Abdeckplatte (11) nach einem der Ansprüche 1 bis 11, wobei die Zirkulationsfläche (18) eine Abdeckungseinheit umfasst.

13. Abdeckplatte (11) nach Anspruch 12, wobei die Abdeckungseinheit aus gehärtetem Glas besteht.

14. Bodenbelagsystem für eine Straße (101), das dazu konfiguriert ist, um eine im Wesentlichen ebene Zirkulationsfläche zu bilden, wobei das Bodenbelagsystem umfasst:
eine Vielzahl von Abdeckplatten (11), die voneinander getrennt und aneinander montiert sind, wobei die Abdeckplatten (11) nach einem der Ansprüche 1 bis 13 jeweils umfassen:
ein Stützgestell (13), das dazu konfiguriert ist, um auf der Straße (101) positioniert zu werden;
ein Abdeckelement (17), das dazu angepasst ist, um das Stützgestell (13) abzudecken, und das umfasst:
eine Zirkulationsfläche (18), wobei die Zirkulationsflächen der Abdeckelemente dazu konfiguriert sind, um die Zirkulationsfläche zu bilden, wenn die Abdeckplatten (11) aneinander montiert sind;
eine Kommunikationseinheit; und
eine Steuereinheit.

15. Bodenbelagsystem für eine Straße (101) nach Anspruch 14, wobei die Steuereinheit jeder der Abdeckplatten (11) unabhängig von den Steuereinheiten der anderen Abdeckplatten (11) konfigurierbar ist.

## Claims

1. A covering slab (11) intended to a pavement system for a pavement (101), the covering slab (11) comprising:
a support frame (13) configured to be positioned on the pavement (101) and comprising a plurality of passage orifices (15), said passage orifices (15) being adapted to allow the passage of power supply elements and/or of communication elements; and
a covering element (17) adapted to cover the support frame (13) and comprising:
a traffic face (18), said traffic face (18) comprising:
a communication unit;
a control unit; and
the control unit and/or the communication unit comprises at least one input/output terminal intended to be connected to a power supply element or to a communication element passing through a passage orifice (15),
**characterized in that** the at least one passage orifice (15) is located in the immediate vicinity of a corner of said support frame (13).

2. The covering slab (11) according to claim 1, wherein the covering element comprises a photovoltaic unit (71).

3. The covering slab (11) according to any one of claims 1 or 2, wherein the covering element (17) comprises an integration box (29) comprising at least one connection orifice (31) adapted to allow the passage of power supply elements or of communication elements.

4. The covering slab (11) according to claim 3, wherein the integration box (29) is fastened to the face of the covering element (17) disposed opposite the pavement (101).

5. The covering slab (11) according to any one of claims 3 or 4, wherein the integration box (29) comprises an electrical energy storage unit.

6. The covering slab (11) according to claim 5, wherein the integration box (29) comprises an electrical energy transfer unit.

7. The covering slab (11) according to any one of claims 3 to 6, wherein the integration box (29) comprises at least one of the following sensors:
brightness sensor;
acoustic sensor;
air quality sensor;
thermal sensor;
identification sensor;
location sensor;
proximity sensor;
load sensor; and
electricity sensor.

8. The covering slab (11) according to any one of claims 3 to 7, wherein the integration box (29) comprises an acoustic emission unit.

9. The covering slab (11) according to any one of claims 1 to 8, wherein the traffic face (18) comprises a light emitting unit.

10. The covering slab (11) according to any one of claims 1 to 9, wherein the traffic face (18) comprises a mechatronic actuator.

11. The covering slab (11) according to any one of claims 1 to 10, wherein the traffic face (18) comprises an electrical transmission unit.

12. The covering slab (11) according to any one of claims 1 to 11, wherein the traffic face (18) comprises a covering unit.

13. The covering slab (11) according to claim 12, wherein the covering unit is made of tempered glass.

14. A pavement system for a pavement (101) configured to form a substantially planar traffic surface, said pavement system comprising:
a plurality of covering slabs (11) distinct from each other and assembled together, each of said covering slabs (11) according to any one of claims 1 to 13 comprising:
a support frame (13) configured to be positioned on the pavement (101);
a covering element (17) adapted to cover the support frame (13) and comprising:
a traffic face (18), the traffic faces of the covering elements being configured to form the traffic surface when the covering slabs (11) are assembled together;
a communication unit; and
a control unit.

15. The pavement system for a pavement (101) according to claim 14, wherein the control unit of each of the covering slabs (11) is configurable independently of the control units of the other covering slabs (11).
